# EUROPÄISCHE PATENTANMELDUNG

(11) **EP 2 581 941 A2**
(43) Veröffentlichungstag der Anmeldung: **17.04.2013**
(21) Anmeldenummer: 12188346.6
(22) Anmeldetag: 12.10.2012
(51) Int. Cl.: H01L 31/02

(54) **Photovoltaikanlage**

(30) Priorität: 15.10.2011 DE 102011116135
(71) Anmelder: Kostal Industrie Elektrik GmbH, 58513 Lüdenscheid (DE)
(72) Erfinder: Burghardt, Frank, 58644 Iserlohn (DE); Forck, Andreas, 45739 Oer-Erkenschwick (DE); Haardt, Mirko, 57234 Wilsndorf (DE)
(74) Vertreter: Kerkmann, Detlef

(57) **Zusammenfassung**

Beschrieben wird eine Photovoltaikanlage mit wenigstens einer Reihenschaltung mehrerer Photovoltaikmodule, wobei jedes Photovoltaikmodul ein Elementfeld zur Erzeugung elektrischer Leistung sowie wenigstens eine steuerbare Schalteranordnung aufweist, welche zwischen einem niederohmigen und einem hochohmigen Schaltzustand zwischen zwei Schalteranschlüssen umschaltbar ist, und mit einer Signalverbindung, welche die wenigstens eine Schalteranordnung des Photovoltaikmoduls mit einem von diesem entfernt angeordneten Freigabesignalgenerator koppelt, welcher zur Erzeugung eines Freigabesignals zur Ansteuerung der Schalteranordnung des Photovoltaikmoduls eingerichtet ist, wobei wenigstens ein Sensor vorhanden ist, welcher zur Detektion eines Störfalls eingerichtet ist und bei Detektion eines Störfalls die Abschaltung des Freigabesignals bewirkt, wobei der Sensor ein für Lichtbogenentladungen charakteristisches breitbandiges hochfrequentes Wechselspannungssignal auf den Verbindungsleitungen detektiert.

## Beschreibung

Die Erfindung betrifft eine Photovoltaikanlage mit den Merkmalen des Oberbegriffs des Anspruchs 1.

An Photovoltaikanlagen treten durch die Reihenschaltung von Photoelementen zu Modulstrings, von Modulstrings zu Photovoltaikmodul und von Photovoltaikmodul zu Modulsträngen (die auch als Strings bezeichnet werden) Spannungen von bis zu 1,5 kV auf. Die Gesamtheit der vorgenannten Komponenten bei einer Photovoltaikanlage wird nach der Zusammenschaltung auch als Photovoltaikgenerator bezeichnet. Üblich ist es, die von einem Photovoltaikgenerator erzeugte Gleichspannung über Verbindungsleitungen einem Spannungswandler, insbesondere einem Wechselrichter zuzuführen. Zumeist generiert der Wechselrichter daraus eine Ausgangsspannung mit dem Spannungswert und der Frequenz der üblichen Netzwechselspannung. Diese Ausgangsspannung kann elektrischen Verbrauchern zugeführt oder in ein Spannungsnetz eingespeist werden.

Aufgrund der hohen Spannungen an den Komponenten des Photovoltaikgenerators und besonders an den Verbindungsleitungen können im Fehlerfall, etwa beim Auftreten von Isolationsfehlern, Lichtbogenentladungen entstehen, von denen weitergehende Schäden und Gefährdungen ausgehen und die daher schnell und sicher erkannt und gelöscht werden müssen.

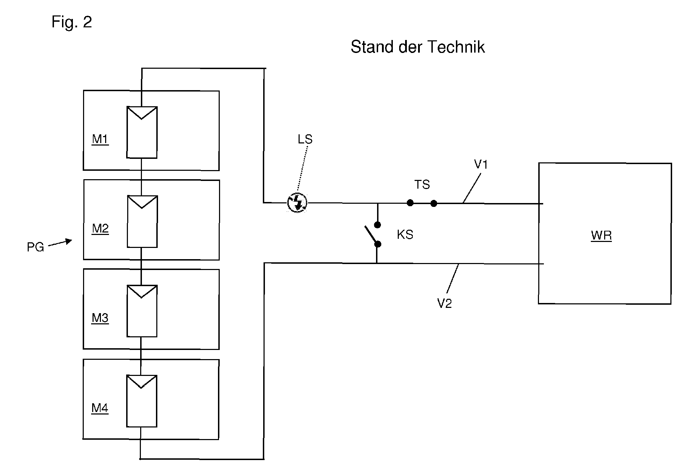

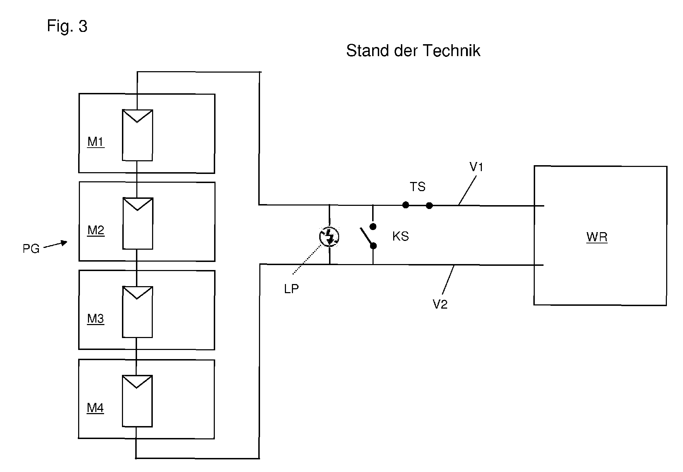

Dabei kann prinzipiell zwischen seriellen Lichtbogenentladungen und parallelen Lichtbogenentladungen unterschieden werden, je nachdem, ob die Lichtbogenentladung entlang einer Verbindungsleitung oder zwischen zwei Verbindungsleitungen auftritt. Diese Unterscheidung soll anhand der Figuren 2 und 3 näher erläutert werden.

Die Figuren 2 und 3 zeigen jeweils eine stark vereinfacht dargestellte Photovoltaikanlage mit einem Photovoltaikgenerator PG, der über zwei Verbindungsleitungen V1, V2 mit dem Eingang eines Wechselrichters WR verbunden ist. Der Photovoltaikgenerator PG ist hier schematisch als eine einfache Reihenschaltung von nur vier Photovoltaikmodulen M1, M2, M3, M4 dargestellt; selbstverständlich sind reale Ausführungen von Photovoltaikgeneratoren im Allgemeinen wesentlich komplexer aufgebaut.

Da die Ausgangsspannung des Photovoltaikgenerators PG üblicherweise einen hohen Wert aufweist, können Fehler in den elektrischen Verbindungsleitungen V1, V2 zu Lichtbogenentladungen führen. Besonders kritisch hierbei ist, dass Gleichspannungslichtbögen nicht von selbst verlöschen und somit ohne geeignete Gegenmaßnahmen für längere Zeit bestehen bleiben können. Hierdurch besteht die Gefahr von Bränden und Personenschäden.

Übliche Mittel gegen Lichtbogenentladungen LS, LP sind Trennschalter TS und Kurzschlussschalter KS in den Verbindungsleitungen V1, V2, die in den Figuren 2 und 3 schematisch dargestellt sind. Diese Schalter TS, KS werden beim Auftreten einer Lichtbogenentladung LS, LP durch eine geeignete Vorrichtung, die in den Figuren nicht dargestellt ist, betätigt oder angesteuert.

Eine serielle Lichtbogenentladung LS, die in der Figur 2 angedeutet ist, entsteht zumeist durch einen schlecht leitenden Abschnitt einer Verbindungsleitung V1 bzw. V2, an dem eine so hohe Spannung abfällt, dass sie zum Zünden einer Lichtbogenentladung LS ausreicht. Danach wird die Lichtbogenentladung LS durch den Lichtbogenstrom aufrechterhalten. Wird der Stromfluss zu diesem Abschnitt der Verbindungsleitung V1 bzw. V2 unterbrochen, so erlischt die Lichtbogenentladung LS. Eine solche Unterbrechung kann durch einen Trennschalter TS erfolgen; allerdings unter der Vorraussetzung, dass der Strom der Lichtbogenentladung LS über den Trennschalter TS fließt. Kommt es zwischen den Verbindungsleitungen V1, V2 zu einer leitenden Verbindung vor dem Trennschalter TS, in der Darstellung der Figur 2 etwa im Bereich des Kurzschlussschalters KS, so bleibt ein Öffnen des Trennschalters TS zur Löschung der Lichtbogenentladung LS wirkungslos.

Aus diesem Grund ist auch der Kurzschlussschalter KS nicht geeignet, eine serielle Lichtbogenentladung LS zu löschen, zumal der geschlossene Kurzschlussschalter KS den Lichtbogenstrom nicht verringert sondern zumeist noch verstärkt.

Gegen einen parallelen Lichtbogen LP, der *zwischen* den Verbindungsleitungen V1, V2 auftritt, ist dagegen ein Kurzschlussschalter KS zumeist wirksam einsetzbar. Wie die Figur 3 zeigt, bewirkt der Kurzschlussschalter KS eine niederohmige Überbrückung der Lichtbogenstrecke, durch die die Spannung an der parallelen Lichtbogenentladung LP soweit absinkt, dass der Lichtbogen erlischt. Hierzu ist es notwendig, dass die Abschnitte der Verbindungsleitungen V1, V2 zwischen dem Ort der Lichtbogenentladung LP und dem Kurzschlussschalter KS intakt sind. Sind diese Abschnitte beim Schließen des Kurzschlussschalters KS, insbesondere durch die Lichtbogenentladung LP, beschädigt, so kann dessen Funktion ausfallen. Wie die Figur 3 weiter zeigt, wird der Trennschalter TS hier nicht wirksam, da er nicht in einen Abschnitt der Verbindungsleitungen V1, V2 zwischen der parallelen Lichtbogenentladung LP und dem Photovoltaikgenerator PG geschaltet ist.

Zusammenfassend ist festzustellen, dass die Wirksamkeit von Trenn- und Kurzschlussschaltern TS, KS zur Löschung von Lichtbogenentladungen LS, LP abhängig ist von der Art der Lichtbogenentladung (seriell oder parallel), vom Ort des Auftretens der Lichtbogenentladung LS, LP relativ zu den Komponenten der Photovoltaikanlage sowie auch von Beschädigungen, die die Lichtbogenentladung LS, LP beim Einsetzen der Löschungsmaßnahmen bereits an den Verbindungsleitungen V1, V2 verursacht hat. Werden diese Gegebenheiten nicht erkannt und berücksichtigt, so ergibt sich eine nicht unerhebliche Wahrscheinlichkeit, dass die beschriebenen Maßnahmen zur Lichtbogenlöschung erfolglos bleiben.

Übliche Verfahren zur Lichtbogendetektion, welche optische Sensoren zur Erfassung einer für Lichtbogen typischen optischen Strahlung aufweisen, sind nachteilig, da der Ort, an dem eine Lichtbogenentladung auftritt, normalerweise nicht vorherzusehen ist und daher für die Überwachung einer räumlich ausgedehnten Photovoltaikanlage eine größere Anzahl von Sensoren erforderlich ist, welche einen erheblichen Kostenaufwand verursachen.

Es stellte sich daher die Aufgabe, eine Photovoltaikanlage zu schaffen, welche auf einfache und kostengünstige Weise eine sichere Erkennung und Löschung von Lichtbogenentladungen ermöglicht.

Diese Aufgabe wird erfindungsgemäß dadurch gelöst, dass der Sensor ein für Lichtbogenentladungen charakteristisches breitbandiges hochfrequentes Wechselspannungssignal auf den Verbindungsleitungen detektiert.

Eine Photovoltaikanlage gemäß dem Oberbegriff des vorliegenden Anspruchs 1 ist in der deutschen Gebrauchsmusterschrift DE 20 2010 008 494 U1 beschrieben.

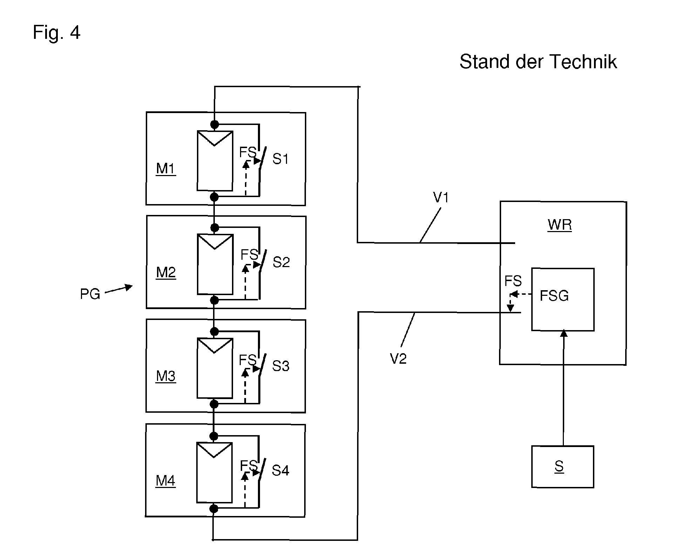

Das in der DE 20 2010 008 494 U1 vorgeschlagene Funktionsprinzip ist in der Figur 4 skizziert. Die dargestellte Photovoltaikanlage weist einen Freigabesignalgenerator FSG auf, der zu einem Wechselrichter WR gehören kann. Der Freigabesignalgenerator FSG erzeugt ein Freigabesignal FS, welches beispielsweise auf eine der Verbindungsleitungen V1, V2 aufmoduliert sein kann und welches parallel zu den Photovoltaikmodulen M1, M2, M3, M4 angeordnete Schaltelemente S1, S2, S3, S4 in den geöffneten Zustand steuert.

Störfallsensoren S, die in der DE 20 2010 008 494 U1 als Rauchmelder oder Hitzesensoren offenbart sind, steuern nach dem Erkennen eines Störfalls den Freigabesignalgenerator FSG an, so dass dieser die Ausgabe des Freigabesignals FS beendet. Nach Wegfall des Freigabesignals FS gehen die Schaltelemente S1, S2, S3, S4 in den geschlossenen Schaltzustand über, in welchem sie die zugeordneten Photovoltaikmodule M1, M2, M3, M4 kurzschließen und damit in einen sicheren Zustand überführen.

Die DE 20 2010 008 494 U1 beschreibt allerdings keine Fehler oder Störfälle, die zu Lichtbogenentladungen führen können. Dem entsprechend sind als Störfallsensoren S auch keine Sensoren offenbart, welche Lichtbogenentladungen erkennen können. Insbesondere finden sich auch keine Angaben dazu, wie ein solcher Sensor beschaffen sein könnte. Ebenso wenig ist das Problem des Erkennens und Löschens unterschiedlicher Arten von Lichtbogenentladungen (serielle und parallele) angesprochen.

Die Erfindung beruht auf der Erkenntnis, dass eine Anlage gemäß der DE 20 2010 008 494 U1 prinzipiell geeignet sein kann, die erfindungsgemäße Aufgabenstellung zu lösen, wenn es gelingt einen Störfallsensor zu schaffen, der auf einfache und kostengünstige Weise sowohl serielle als auch parallele Lichtbogenentladungen detektieren kann.

Erfindungsgemäß wird ein Lichtbogendetektor LD vorgeschlagen, der das Auftreten von Lichtbogenentladungen am Vorliegen von hochfrequenten Wechselspannungssignalen erkennt.

Lichtbogenentladungen erzeugen ein sehr breitbandiges Spektrum von Störfrequenzen. Es hat sich als vorteilhaft erwiesen, zur Detektion von Lichtbogenentladungen hochfrequente Signale eines Frequenzbereichs zu erfassen, die in einem Teilbereich des Frequenzbandes zwischen 100 kHz und 1 MHz liegen. Der Teilbereich wird dabei so gewählt, dass dieser einerseits für Lichtbogenentladungen typische Störfrequenzen enthält, sich aber andererseits nicht mit dem Störfrequenzspektrum anderer möglicher Störquellen überschneidet.

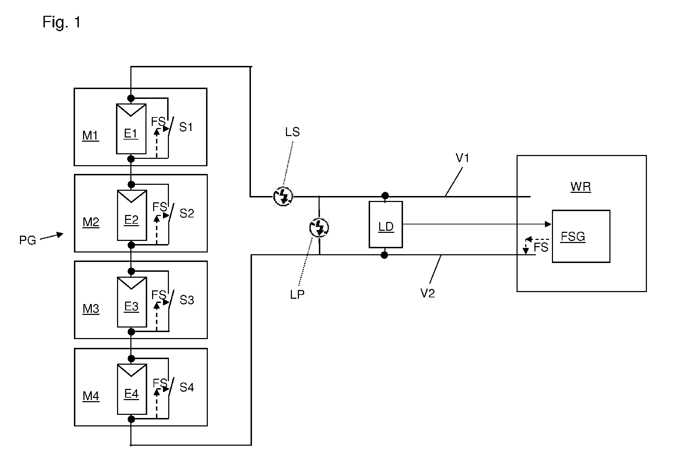

Die Figur 1 zeigt eine erfindungsgemäße Photovoltaikanlage mit einem Lichtbogendetektor LD, der an die Verbindungsleitungen V1, V2 angekoppelt ist und diese auf das Auftreten breitbandiger hochfrequenter Wechselspannungssignale überwacht. Der als Blockschaltbild dargestellte Lichtbogendetektor LD kann dazu beispielsweise als Bandpass geschaltete analoge Frequenzfilter aufweisen, oder aber eine digitale Anordnung enthalten, welche vorhandene Frequenzanteile eines Frequenzspektrum analysieren kann (Fourier-Analyse).

Beim Auftreten eines breitbandigen hochfrequenten Wechselspannungssignals, welches auf ein Lichtbogenereignis hindeutet, steuert der Lichtbogendetektor LD den Freigabesignalgenerator FSG an, welcher daraufhin die Ausgabe des Freigabesignals FS einstellt. Durch das nicht mehr in den Photovoltaikmodulen M1, M2, M3, M4 vorliegende Freigabesignal FS gehen die Schaltanordnungen S1, S2, S3, S4 in den geschlossenen Zustand über und überbrücken so die spannungserzeugenden Elementfelder E1, E2, E3, E4. Die Photovoltaikmodule M1, M2, M3, M4 werden so intern kurzgeschlossen. Dadurch wird der aktiven Lichtbogenentladung LS bzw. LP die Energie entzogen, so dass diese erlischt. Dies funktioniert unerheblich davon, ob es sich um eine serielle oder eine parallele Lichtbogenentladung LS bzw. LP handelt.

Besonders vorteilhaft ist, dass der Lichtbogendetektor LD weder den genauen Ort noch die Art der Lichtbogenentladung LS, LP bestimmen, sondern lediglich das Auftreten einer Lichtbogenentladung LS, LP erkennen muss. Das Löschen erfolgt dann dezentral auf der Ebene der Photovoltaikmodule M1, M2, M3, M4 als Reaktion auf das ausbleibende, zentral gesteuerte Freigabesignal FS.

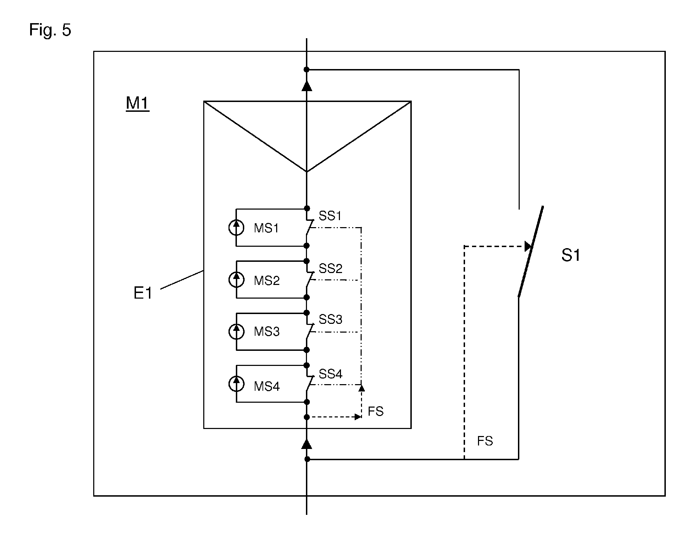

Eine vorteilhafte Weiterbildung der erfindungsgemäßen Photovoltaikanlage ist in der Figur 5 skizziert. Die Figur zeigt eine erweiterte Ansicht eines der Photovoltaikmodule (hier rein beispielhaft das mit dem Bezugszeichen M1 bezeichnete) eines Photovoltaikgenerators, wie er in der Figur 1 dargestellt ist. Erkennbar ist, dass das spannungserzeugende Elementfeld E1 eine Reihenschaltung mehrerer so genannter Modulstrings MS1, MS2, MS3, MS4 aufweist, welche wiederum jeweils aus mehreren, hier nicht dargestellten Photozellen bestehen.

Besonders vorteilhaft ist, dass jedem der Modulstrings MS1, MS2, MS3, MS4 ein Modulfreischaltelement SS1, SS2, SS3, SS4 parallelgeschaltet ist, welches im Ruhezustand den zugeordneten Modulstring MS1, MS2, MS3, MS4 überbrückt. Beim Anliegen des über die Verbindungsleitungen zugeführten Freigabesignals FS öffnen die Modulfreischaltelemente SS1, SS2, SS3, SS4 und schalten so die Spannungen der Modulstrings MS1, MS2, MS3, MS4 auf die Anschlussleitungen des Photovoltaikmoduls M1. Diese zusätzliche Freigabesteuerung auf der Ebene der Modulstrings MS1, MS2, MS3, MS4 schafft eine noch höhere Funktionssicherheit durch die Schaffung einer weiteren Freischaltinstanz. Besonders vorteilhaft ist, dass auf der Ebene der Modulstrings MS1, MS2, MS3, MS4 weitaus kleinere Spannungen und elektrische Leistungen zu schalten sind als auf der Ebene der Photovoltaikmodule M1, M2, M3, M4.

Falls eine Lichtbogenentladung auf Modulstringebene zu löschen ist, so wird durch das Wegschalten aller anderen Module und Teilstrings die Spannung über dem Lichtbogen auf die des betroffenen Modulteilstrings reduziert. Da auf Modulstringebene die Spannungen und Ströme relativ zur Gesamtanlage sehr gering sind, reicht die Energie nicht aus, um einen dauerhaften Lichtbogen zu speisen, so dass dieser erlischt.

### Bezugszeichen

- E1, E2, E3, E4: Elementfelder
- FSG: Freigabesignalgenerator
- FS: Freigabesignal
- KS: Kurzschlussschalter
- LD: Lichtbogendetektor (Sensor)
- LP: parallele Lichtbogenentladung
- LS: serielle Lichtbogenentladung
- M1, M2, M3, M4: Photovoltaikmodule
- MS1, MS2, MS3, MS4: Modulstrings
- PG: Photovoltaikgenerator
- S: Störfallsensor(en)
- S1, S2, S3, S4: Schaltelemente (Schalteranordnung)
- SS1, SS2, SS3, SS4: Modulfreischaltelemente
- TS: Trennschalter
- V1, V2: Verbindungsleitungen
- WR: Wechselrichter

## Patentansprüche

1. Photovoltaikanlage mit wenigstens einer Reihenschaltung mehrerer Photovoltaikmodule (M1, M2, M3, M4), wobei jedes Photovoltaikmodul (M1, M2, M3, M4) ein Elementfeld (E1, E2, E3, E4) zur Erzeugung elektrischer Leistung sowie wenigstens eine steuerbare Schalteranordnung (S1, S2, S3, S4) aufweist, welche zwischen einem niederohmigen und einem hochohmigen Schaltzustand zwischen zwei Schalteranschlüssen umschaltbar ist, und mit einer Signalverbindung, welche die wenigstens eine Schalteranordnung (S1, S2, S3, S4) des Photovoltaikmoduls (M1, M2, M3, M4) mit einem von diesem entfernt angeordneten Freigabesignalgenerator (FSG) koppelt, welcher zur Erzeugung eines Freigabesignals (FS) zur Ansteuerung der Schalteranordnung (S1, S2, S3, S4) des Photovoltaikmoduls (M1, M2, M3, M4) eingerichtet ist, wobei wenigstens ein Sensor (S, LD) vorhanden ist, welcher zur Detektion eines Störfalls eingerichtet ist und bei Detektion eines Störfalls die Abschaltung des Freigabesignals (FS) bewirkt,
**dadurch gekennzeichnet,**
**dass** der Sensor (LD) ein für Lichtbogenentladungen charakteristisches breitbandiges hochfrequentes Wechselspannungssignal auf den Verbindungsleitungen (V1, V2) detektiert.

2. Photovoltaikanlage nach Anspruch 1, **dadurch gekennzeichnet, dass** die Schalteranordnung (S1, S2, S3, S4) monostabil den niederohmigen Schaltzustand als Ruhezustand besitzt und mittels des externen Freigabesignals (FS) in den hochohmigen Schaltzustand versetzbar und in diesem haltbar ist und nach Wegfall des Freigabesignals (FS) in den Ruhezustand zurückkehrt,

3. Photovoltaikanlage nach Anspruch 1, **dadurch gekennzeichnet, dass** das Freigabesignal (FS) auf wenigstens eine der Verbindungsleitungen (V1, V2) moduliert ist.

4. Photovoltaikanlage nach Anspruch 1, **dadurch gekennzeichnet, dass** zur Detektion des Wechselspannungssignals ein Teilbereichs des Frequenzbandes zwischen 100 kHz und 1 MHz erfasst wird.

5. Photovoltaikanlage nach Anspruch 4, **dadurch gekennzeichnet, dass** zur Detektion des Wechselspannungssignals analoge Frequenzfilter vorgesehen sind.

6. Photovoltaikanlage nach Anspruch 4, **dadurch gekennzeichnet, dass** zur Detektion des Wechselspannungssignals digitale Mittel zu Analyse des Frequenzspektrums vorgesehen sind.

7. Photovoltaikanlage nach Anspruch 1, **dadurch gekennzeichnet, dass** die Photovoltaikmodule (M1, M2, M3, M4) jeweils mehrere Modulstrings (MS1, MS2, MS3, MS4) aufweisen, denen jeweils ein Modulfreischaltelement (SS1, SS2, SS3, SS4) parallelgeschaltet ist.

8. Photovoltaikanlage nach Anspruch 7, **dadurch gekennzeichnet, dass** der Freigabesignalgenerator (FSG) den Schaltzustand der Modulfreischaltelemente (SS1, SS2, SS3, SS4) steuert.
